# EUROPÄISCHE PATENTSCHRIFT

(11) **EP 2 944 505 B1**
(45) Veröffentlichungstag und Bekanntmachung des Hinweises auf die Patenterteilung: **04.09.2019**
(21) Anmeldenummer: 15166728.4
(22) Anmeldetag: 07.05.2015
(51) Int. Cl.: B60L 50/50, G01R 31/36

(54) **VERFAHREN ZUR BESTIMMUNG EINER RESTLAUFZEIT EINES FLURFÖRDERZEUGS**
METHOD FOR DETERMINING THE REMAINING TIME OF AN INDUSTRIAL TRUCK
PROCÉDÉ DE DÉTERMINATION DE MESURE DE L'AUTONOMIE RESTANTE D'UN CHARIOT DE MANUTENTION

(30) Priorität: 16.05.2014 DE 102014106984
(43) Veröffentlichungstag der Anmeldung: 18.11.2015
(73) Patentinhaber: STILL GmbH, 22113 Hamburg (DE)
(72) Erfinder: Morawietz, Lutz, 01277 Dresden (DE); Wede, Marc, 22941 Bargteheide (DE)
(74) Vertreter: Patentship Patentanwaltsgesellschaft mbH

(56) Entgegenhaltungen:
- EP-A1- 2 096 453
- EP-A1- 2 520 537
- WO-A1-2013/042495
- DE-A1-102009 013 649
- JP-A- 2010 037 011
- US-A1- 2006 089 844
- US-A1- 2014 058 635

## Beschreibung

Die Erfindung betrifft ein Verfahren zur Bestimmung einer Restlaufzeit eines Flurförderzeugs. Insbesondere betrifft die Erfindung ein Verfahren zur Bestimmung einer Restlaufzeit eines Flurförderzeugs mit einem Energiespeicher des Flurförderzeugs, mit Sensormitteln zur Erfassung eines Füllungsgrades des Energiespeichers, mit einem Steuergerät und mit einer Anzeigevorrichtung, wobei das Flurförderzeug mindestens zwei Betriebsmodi aufweist, durch die beim Betrieb des Flurförderzeugs ein Fahrantrieb und/oder eine Arbeitsvorrichtung einen unterschiedlichen Energieverbrauch aufweisen, und das Steuergerät eine Restlaufzeit bestimmt, indem der Energiegehalt des Energiespeichers mithilfe des Füllungsgrades bestimmt wird, sowie aus dem Energiegehalt und einem mittleren Energieverbrauch die Restlaufzeit berechnet.

Bei Flurförderzeugen, beispielsweise Schubmaststaplern oder Gegengewichtsgabelstaplern, sind sowohl Ausführungen bekannt, die batterie-elektrisch angetrieben, als auch durch einen Verbrennungsmotor als Energiequelle betrieben werden.

Bei batterie-elektrisch betriebenen Flurförderzeugen werden Traktionsbatterien benutzt, die in ein Batteriefach des Flurförderzeugs austauschbar eingesetzt werden. Die Traktionsbatterie kann dann im Mehrschichtbetrieb durch eine aufgeladene Traktionsbatterie ersetzt werden, sobald diese entladen ist. Als Traktionsbatterie kommen dabei überwiegend Blei-Säurebatterien oder auch eventuell in einer Blei-Geltechnologie ausgeführte zum Einsatz. Zunehmend werden auch Hochleistungsbatterien eingesetzt, die eine höhere Energiedichte bei geringerem Gewicht aufweisen, vor allem Batterien mit Lithium-Ionentechnologie.

Bei allen diesen Traktionsbatterie besteht nur die Möglichkeit, eine begrenzte elektrische Energie zu speichern. Die im tatsächlichen Einsatz bei dem Flurförderzeug zur Verfügung stehende Energie dieser Traktionsbatterie ist dabei im Regelfall geringer und wird konstruktiv begrenzt, um eine Schädigung der Traktionsbatterie, insbesondere der Batteriezellen, infolge von einer Tiefentladung auszuschließen oder zumindest zu minimieren. Ebenfalls aus diesem Grund, um eine rechtzeitigen Tausch der Traktionsbatterie noch vor einer Tiefentladung zu fördern und möglichst sicherzustellen, werden die Flurförderzeuge mit Überwachungssystemen für die Traktionsbatterie ausgestattet, die einen ausreichend genauen Ladezustand, auch bezeichnet als "State Of Charge", abgekürzt "SOC", bestimmen und für eine Bedienperson bzw. einen Fahrer anzeigen.

Durch einen Verbrennungsmotor angetriebene Flurförderzeuge weisen in der Regel Sensoren auf, um den Füllstand eines Kraftstoffbehälters zu erfassen. Bei benzin- oder dieselbetriebenen Flurförderzeugen sind dies zumeist Sensoren, die den Flüssigkeitsstand in einem Kraftstofftank erfassen, beispielsweise über Schwimmsensoren. Wenn bei Verbrennungsmotoren Treibgas verwendet wird, wird häufig nur ein Druckschalter eingesetzt, der bei Unterschreiten eines bestimmten Druckwertes schaltet und diesen Zustand anzeigt. Es ist ebenfalls möglich, hier einen Sensor vorzusehen, der den tatsächlichen Füllstand der Gas-Flasche messen kann und hierdurch eine kontinuierliche Messung des Füllstandes ermöglicht.

Durch diese nach dem Stand der Technik bekannten Lösungen wird jedoch nicht eine Restnutzungsdauer bestimmt. Vielmehr muss anhand der Anzeige eine Bedienperson bzw. ein Fahrer selbst eine Restnutzungsdauer abschätzen.

Der Einsatz von Flurförderzeugen in den Betrieben wird sehr häufig möglichst weitgehend optimiert für die betreffenden Transportaufgaben. Dies erstreckt sich insbesondere auch darauf, dass auf der Basis einer möglichst optimalen Kosten-Nutzenanalyse geeignete Traktionsbatterien sowie eine geeignete Ladeinfrastruktur eingesetzt wird. Dabei werden die Traktionsbatterie wie auch die Lademöglichkeiten möglichst knapp bemessen, um Kosten zu optimieren. Um dann einen möglichst optimalen Einsatz zu gewährleisten, vor allem auch bei mehreren Flurförderzeugen, ist eine möglichst zuverlässige Vorhersage erforderlicher Nachladevorgänge bei der Traktionsbatterie oder eines erforderlichen Tausches der Traktionsbatterie vorteilhaft.

Für eine solche möglichst genaue Vorhersage ist eine hinreichend genaue Bestimmung des Ladezustands der Traktionsbatterie und eine Interpretation erforderlich, wie lange das Flurförderzeug mit der noch vorhandenen Restladung der Traktionsbatterie noch betrieben werden kann. Bei den geschilderten, aus dem Stand der Technik bekannten Lösungen kann dies der Fahrer oder eine Bedienperson nur auf der Basis von Erfahrungswerten ableiten.

Zur Lösung dieses Problems ist es bei Flurförderzeugen bekannt, eine Restlaufzeit auf der Basis einer nutzbaren Restenergiemenge des Energiespeichers, beispielsweise des Ladezustands einer Traktionsbatterie, der Nennkapazität des Energiespeichers und der abgerufenen Leistung, beispielsweise einer elektrischen Leistung der Verbraucher des Flurförderzeugs zu ermitteln. Zusätzlich können noch weitere Größen unterstützend verwendet werden, die den Einsatz des Flurförderzeugs bewerten und beispielsweise einen Fahrbetrieb von einem Lasthandhabungsbetrieb unterscheiden wie auch Einsatzzeiten von Pausenzeiten. Dabei wird der aktuelle Energieverbrauch bestimmt, gegebenenfalls auch der Energieverbrauch in zuvorliegenden Zeiträumen. Eine Restnutzungsdauer wird dann anhand beispielsweise eines Ladezustands multipliziert mit einer nutzbaren Kapazität bzw. Nennkapazität der Traktionsbatterie ermittelt, wobei dieser Wert durch eine mittlere abgerufenen Leistung dividiert wird. Die mittlere abgerufenen Leistung stellt dabei einen Mittelwert über einen sinnvoll gewählten Zeitraum dar, der sich unmittelbar auf einen Zeitraum vor der Bestimmung der Restnutzungsdauer beziehen kann, oder auch auf mehrere zuvorliegende Zeiträume. Durch die Mittelwertbildung erfolgt eine Filterung und Glättung des aktuellen Energieverbrauchs, beispielsweise des gemessenen Gesamtstroms bei einem elektrisch betriebenen Fahrzeug, der aufgrund der Bedienungsbefehle des Fahrers oder Bediener rasch und kurzfristig stark schwankt.

Die dadurch ermöglichte Restlaufzeitanzeige kann entweder auf der Basis von Zeitanteilen allein des aktiven Fahrzeugbetriebs, beispielsweise den Betriebsstunden, berechnet werden, oder auf der Basis der Zeit und somit inklusive von Pausenzeiten während des Einsatzes des Flurförderzeugs.

Nachteilig an diesem Stand der Technik ist, dass grundsätzlich davon ausgegangen wird, dass der Stromverbrauch des Flurförderzeugs im Betrieb im Wesentlichen stets gleich ist und zum Beispiel nicht von bestimmten Steuerungsprogramm und ausgewählten Betriebsmodi abhängt.

Es ist bekannt, bei Flurförderzeugen verschiedene Betriebsmodi vorzusehen. Durch diese Betriebsmodi wird eine Anpassung des Energieverbrauchs möglich, beispielsweise indem im Fahrbetrieb bestimmte Beschleunigungskurven und/oder maximale Geschwindigkeiten eingehalten werden müssen. Weiterhin kann durch die Betriebsmodi auch eine Anpassung an Vorgaben in einem Arbeitsbereich auf einem Betriebsgelände erfolgen, beispielsweise eine Limitierung eine Höchstgeschwindigkeit. Auch ist es denkbar, dass bestimmte optionale und zusätzliche Verbraucher nur in bestimmten Betriebsmodi zur Verfügung stehen, beispielsweise eine elektrische Kabinenheizung.

Die DE 10 2009 013 649 A1 offenbart ein Verfahren zur Bestimmung einer Restbetriebszeit eines batteriebetriebenen Flurförderzeugs auf Basis eines Berechnungsstromverbrauchs, der anhand geschätzter Arbeitszyklen zuvor festgelegt wird. Typische Arbeitszyklen können für großflächige Lager mit niedrigen Regalen oder Hallenlager mit hohen Regalen berücksichtigt werden.

Der vorliegenden Erfindung liegt daher die Aufgabe zugrunde, ein Verfahren zur Bestimmung einer Restlaufzeit eines Flurförderzeugs zur Verfügung zu stellen, das die zuvor genannten Nachteile vermeidet und mit dem eine bessere sowie genauere Bestimmung der Restlaufzeit möglich ist.

Diese Aufgabe wird durch ein Verfahren zur Bestimmung einer Restlaufzeit eines Flurförderzeugs mit den Merkmalen des unabhängigen Patentanspruchs 1 gelöst. Vorteilhafte Weiterbildungen der Erfindung sind in den Unteransprüchen angegeben.

Die Aufgabe wird erfindungsgemäß dadurch gelöst, dass bei einem Verfahren zur Bestimmung einer Restlaufzeit eines Flurförderzeugs mit einem Energiespeicher des Flurförderzeugs, mit Sensormitteln zur Erfassung eines Füllungsgrades des Energiespeichers, mit einem Steuergerät und mit einer Anzeigevorrichtung, wobei das Flurförderzeug mindestens zwei Betriebsmodi aufweist, durch die beim Betrieb des Flurförderzeugs ein Fahrantrieb und/oder eine Arbeitsvorrichtung einen unterschiedlichen Energieverbrauch aufweisen, und das Steuergerät eine Restlaufzeit bestimmt, indem der Energiegehalt des Energiespeichers mithilfe des Füllungsgrades bestimmt wird, sowie aus dem Energiegehalt und einem mittleren Energieverbrauch die Restlaufzeit berechnet und auf der Anzeigevorrichtung anzeigt, wobei die Betriebsmodi unterschiedliche einzuhaltende Beschleunigungskurven und/oder maximale Geschwindigkeiten im Fahrbetrieb aufweisen, und bei einem Wechsel des Betriebsmodus der mittlere Energieverbrauch durch einen Korrekturwert für den Betriebsmodus angepasst wird.

Vorteilhaft erfolgt dadurch genauer eine Vorhersage der Restlaufzeit. Insbesondere kommt es nicht zu einer falschen Darstellung bei einem Wechsel eines Betriebsmodus. Die zeitliche Filterung des Signals bzw. Bildung eines Mittelwertes muss mit einer relativ großen Zeitkonstante erfolgen, damit das im Betrieb stark schwankende Signal des Energieverbrauchs ausreichend geglättet bzw. aus diesem ein Mittelwert gebildet wird. So sind Werte der Mittelwertbildung aus bis zu einer halben Stunde nicht unüblich. Bei einem Wechsel des Betriebsmodus von einem ersten Betriebsmodus in einen zweiten, bei dem zum Beispiel in dem zweiten Betriebsmodus ein erheblich geringerer Energieverbrauch entsteht, etwa beispielsweise nur 70 %, würde somit eine falsche Anzeige der Restlaufzeit für einen noch längeren Zeitraum erfolgen. Indem durch den Korrekturwert sofort eine Anpassung erfolgt, wird mit dem Umschalten bereits eine richtige Restlaufzeit angezeigt.

Vorteilhaft wird das Flurförderzeug batterie-elektrisch betrieben und der Energiespeicher ist eine Traktionsbatterie sowie der Füllungsgrad entspricht einem Ladezustand.

Die Restlaufzeit kann als Betriebsstunden angezeigt werden.

Häufig wird bei Flurförderzeugen die Anzahl der Betriebsstunden mitgerechnet und registriert, wenn das Fahrzeug Arbeit verrichtet, folglich fährt, oder eine Last bewegt. Wenn die Restlaufzeit in Betriebsstunden angegeben wird, ist dann zu ersehen, wie viele Betriebsstunden das Fahrzeug noch eingesetzt werden kann, ohne dass Pausenzeiten berücksichtigt werden. Anderenfalls erfolgt die Berechnung nach den Durchschnittswerten und werden die Pausenzeiten eingeschlossen, so dass in der Restlaufzeit auch ein durchschnittlicher Anteil an Pausenzeiten und Standzeiten enthalten ist. Es ist natürlich auch denkbar, einen konkreten Zeitpunkt für das Betriebsende bzw. die Erschöpfung des Energiespeichers anzugeben.

Vorteilhaft zeigt die Steuerung auf der Anzeigevorrichtung den Füllungsgrad und die Restlaufzeit alternierend an, insbesondere einen Ladezustand und die Restlaufzeit bei einem batterie-elektrischen Flurförderzeug.

Dies ermöglicht die Integration der Anzeige der Restlaufzeit in eine Anzeige des Füllungsgrades, insbesondere des Ladezustands bei einem batterie-elektrisch angetriebenen Flurförderzeug.

Die Steuerung kann auf der Anzeigevorrichtung eine optionale Restlaufzeit für den oder die nicht aktiven Betriebsmodi anzeigen.

Dadurch kann dem Fahrer angezeigt werden, dass der Wechsel des Betriebsmodus, insbesondere der Wechsel zu, oder von einem Betriebsmodus, der einen Energie-Sparmodus darstellt, eine Verlängerung oder Verkürzung der Restlaufzeit bewirkt.

In vorteilhafter Ausgestaltung wird das Flurförderzeug durch einen Verbrennungsmotor betrieben und der Energiespeicher ist ein Kraftstoffbehälter sowie der Füllungsgrad entspricht einem Füllstand des Kraftstoffbehälters.

Je nach der Ausgestaltung des Antriebssystems, beispielsweise einem hydrodynamischen Wandler oder einem elektrischen Getriebe bestehend aus Generator-Wechselrichter-Elektromotor, muss bei dieser Ausführungsform die mechanische oder elektrische Leistung errechnet werden.

Die Steuerung kann die Restlaufzeit in ein Datennetz an ein Flotten-Managementsystem übertragen.

Die Übertragung kann durch einen Funksender drahtlos erfolgen.

Dadurch können Flotten-Managementsysteme unterstützt werden und vernetzte Flurförderzeuge über eine zentrale Station verwaltet werden. Geeignete Lade- oder Tauschzeitpunkte für Traktionsbatterien bei beispielsweise batterie-elektrischen Flurförderzeugen können verwaltet werden und es wird eine weitere Optimierung des Einsatzes der Flurförderzeuge inklusive der Infrastruktur ermöglicht.

In einer weiteren Ausgestaltung des Verfahrens weist das Flurförderzeug optionale Verbraucher auf und wird bei einem Zuschalten oder Abschalten des optionalen Verbrauchers der mittlere Energieverbrauch durch einen Korrekturwert angepasst.

Vor allem bei optionalen Verbrauchern mit relativ großem Energieverbrauch, wie beispielsweise einer elektrischen Kabinenheizung, aber auch einer mit Kraftstoff betriebenen Standheizung, ergeben sich die bereits zuvor geschilderten Vorteile, dass unmittelbar nach dem Einschalten oder Abschalten die Restlaufzeit richtig angezeigt wird.

Vorteilhaft kann die Steuerung auf der Anzeigevorrichtung eine optionale Restlaufzeit für zugeschaltete/abgeschaltete optionale Verbraucher anzeigen.

Dadurch kann dem Fahrer angezeigt werden, dass das Zuschalten oder Abschalten des optionalen Verbrauchers eine Verlängerung oder Verkürzung der Restlaufzeit bewirkt.

Weitere Vorteile und Einzelheiten der Erfindung werden anhand der in den schematischen Figuren dargestellten Ausführungsbeispiele näher erläutert. Hierbei zeigt
- Fig. 1: schematisch das erfindungsgemäße Verfahren bei einem batterieelektrischen Flurförderzeug und
- Fig. 2: schematisch das erfindungsgemäße Verfahren bei einem durch Verbrennungsmotor angetriebenen Flurförderzeug.

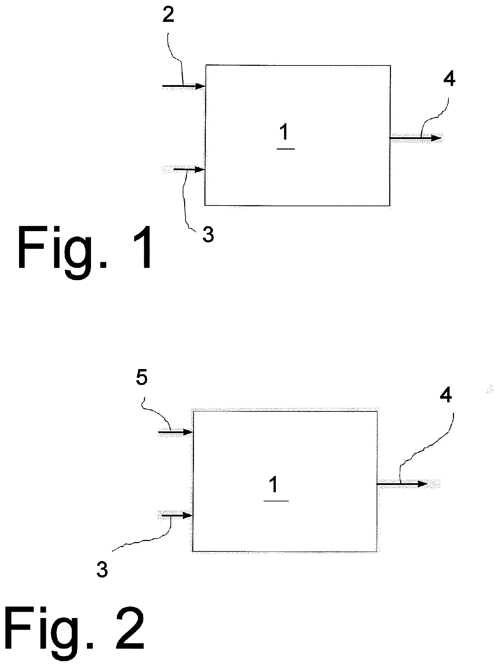

Die Fig. 1 zeigt schematisch das erfindungsgemäße Verfahren bei einem batterie-elektrischen Flurförderzeug. In einer Steuerung 1 erfolgt die Bestimmung der Restlaufzeit. Hierzu werden ein Ladezustand einer Traktionsbatterie, die Nennkapazität der Traktionsbatterie und optional auch der Batterietyp als Batteriegrößen 2 der Steuerung 1 zugeführt. Als Parameter 3 der Antriebs- und Fahrzeugsysteme werden die elektrische Leistung, der zurzeit genutzte Betriebsmodus und gegebenenfalls ein- bzw. ausgeschaltete optionale Verbraucher der Steuerung 1 zugeführt. In der Steuerung 1 erfolgt eine Filterung der elektrischen Leistung, durch die ein Mittelwert gebildet wird. Anschließend wird die elektrische Leistung unter Berücksichtigung des aktiven Modus bzw. optionaler Verbraucher korrigiert, falls gerade ein Wechsel erfolgte. Auf der Basis der elektrischen Leistung wird sodann die Restlaufzeit 4 bestimmt. Zusätzlich ist es denkbar, Betriebssituationen zu berücksichtigen, etwa ob gefahren wird oder gehoben wird.

Die Fig. 2 zeigt schematisch das erfindungsgemäße Verfahren bei einem durch einen Verbrennungsmotor angetriebenen Flurförderzeug. In der Steuerung 1 erfolgt die Bestimmung der Restlaufzeit 4. Hierzu werden ein Füllstand eines Kraftstoffbehälters, ein Fassungsvermögen des Kraftstoffbehälters sowie Verbrauchskennfelder des Verbrennungsmotors und die mechanische Leistung des Verbrennungsmotors als Kraftstoffbehälter- und Verbrennungsmotorgrößen 5 der Steuerung 1 zugeführt. Als Parameter 3 der Antriebs- und Fahrzeugsysteme werden die mechanische oder elektrische Leistung, der zurzeit genutzte Betriebsmodus und gegebenenfalls ein- bzw. ausgeschaltete optionale Verbraucher der Steuerung 1 zugeführt. In der Steuerung 1 erfolgt eine Umrechnung der Lasten auf eine mechanische Leistung des Verbrennungsmotors bzw. eine Filterung der mechanischen Leistung des Verbrennungsmotors, durch die ein Mittelwert gebildet wird. Anschließend wird die Leistung unter Berücksichtigung des aktiven Modus bzw. optionaler Verbraucher korrigiert, falls gerade ein Wechsel erfolgte. Auf der Basis der Leistung wird sodann die Restlaufzeit 3 bestimmt, wobei der Verbrennungsmotorbetrieb mit seinen zugehörigen Kennfeldern berücksichtigt werden kann. Zusätzlich ist es denkbar, Betriebssituationen zu berücksichtigen, etwa ob gefahren wird oder gehoben wird.

## Patentansprüche

1. Verfahren zur Bestimmung einer Restlaufzeit (4) eines Flurförderzeugs mit einem Energiespeicher des Flurförderzeugs, mit Sensormitteln zur Erfassung eines Füllungsgrades des Energiespeichers, mit einem Steuergerät und mit einer Anzeigevorrichtung, wobei das Flurförderzeug mindestens zwei Betriebsmodi aufweist, durch die beim Betrieb des Flurförderzeugs ein Fahrantrieb und/oder eine Arbeitsvorrichtung einen unterschiedlichen Energieverbrauch aufweisen, und das Steuergerät eine Restlaufzeit (4) bestimmt, indem der Energiegehalt des Energiespeichers mithilfe des Füllungsgrades bestimmt wird, sowie aus dem Energiegehalt und einem mittleren Energieverbrauch die Restlaufzeit (4) berechnet und auf der Anzeigevorrichtung anzeigt,
**dadurch gekennzeichnet,**
**dass** die Betriebsmodi unterschiedliche einzuhaltende Beschleunigungskurven und/oder maximale Geschwindigkeiten im Fahrbetrieb aufweisen, und dass bei einem Wechsel des Betriebsmodus der mittlere Energieverbrauch durch einen Korrekturwert für den Betriebsmodus angepasst wird.

2. Verfahren nach Anspruch 1,
**dadurch gekennzeichnet,**
**dass** das Flurförderzeug batterie-elektrisch betrieben und der Energiespeicher eine Traktionsbatterie ist sowie der Füllungsgrad einem Ladezustand entspricht.

3. Verfahren nach Anspruch 1 oder 2,
**dadurch gekennzeichnet,**
**dass** die Restlaufzeit (4) als Betriebsstunden angezeigt wird.

4. Verfahren nach einem der Ansprüche 1 bis 3,
**dadurch gekennzeichnet,**
**dass** die Steuerung auf der Anzeigevorrichtung den Füllungsgrad und die Restlaufzeit (4) alternierend anzeigt, insbesondere einen Ladezustand bei einem batterie-elektrischen Flurförderzeug.

5. Verfahren nach einem der Ansprüche 1 bis 4,
**dadurch gekennzeichnet,**
**dass** die Steuerung auf der Anzeigevorrichtung eine optionale Restlaufzeit für den oder die nicht aktiven Betriebsmodi anzeigen kann.

6. Verfahren nach einem der Ansprüche 1 bis 5,
**dadurch gekennzeichnet,**
**dass** das Flurförderzeug durch einen Verbrennungsmotor betrieben wird und der Energiespeicher ein Kraftstoffbehälter ist sowie der Füllungsgrad einem Füllstand des Kraftstoffbehälters entspricht.

7. Verfahren nach einem der Ansprüche 1 bis 6,
**dadurch gekennzeichnet,**
**dass** die Steuerung die Restlaufzeit (4) in ein Datennetz an ein Flotten-Managementsysteme übertragen kann..

8. Verfahren nach Anspruch 7,
**dadurch gekennzeichnet,**
**dass** die Übertragung durch einen Funksender drahtlos erfolgen kann.

9. Verfahren nach einem der Ansprüche 1 bis 8,
**dadurch gekennzeichnet,**
**dass** das Flurförderzeug optionale Verbraucher aufweist und bei einem Zuschalten oder Abschalten des optionalen Verbrauchers der mittlere Energieverbrauch durch einen Korrekturwert angepasst wird.

10. Verfahren nach Anspruch 9,
**dadurch gekennzeichnet,**
**dass** die Steuerung auf der Anzeigevorrichtung eine optionale Restlaufzeit (4) für zugeschaltete/abgeschaltete optionale Verbraucher anzeigen kann.

## Claims

1. Method for determining a remaining time (4) of an industrial truck with an energy store of the industrial truck, with sensor means for detecting a fill level of the energy store, with a control unit and with a display device, wherein the industrial truck has at least two operating modes by virtue of which, during operation of the industrial truck, a drive and/or an operating device have a different energy consumption, and the control unit determines a remaining time (4) by determining the energy content of the energy store using the fill level, and calculates the remaining time (4) from the energy content and an average energy consumption and displays this on the display device,
**characterized**
**in that** the operating modes have different acceleration curves and/or maximum speeds to be respected during driving operation, and in that, in the event of a change of the operating mode, the average energy consumption is adjusted by a correction value for the operating mode.

2. Method according to Claim 1,
**characterized**
**in that** the industrial truck is electric battery-operated and the energy store is a traction battery and the fill level corresponds to a state of charge.

3. Method according to Claim 1 or 2,
**characterized**
**in that** the remaining time (4) is displayed in the form of operating hours.

4. Method according to one of Claims 1 to 3,
**characterized**
**in that** the controller alternately displays the fill level and the remaining time (4) on the display device, in particular a state of charge in the case of an electric-battery industrial truck.

5. Method according to one of Claims 1 to 4,
**characterized**
**in that** the controller is able to display an optional remaining time for the inactive operating mode or modes on the display device.

6. Method according to one of Claims 1 to 5,
**characterized**
**in that** the industrial truck is driven by a combustion engine and the energy store is a fuel tank and the fill level corresponds to a filling level of the fuel tank.

7. Method according to one of Claims 1 to 6,
**characterized**
**in that** the controller is able to transmit the remaining time (4) in a data network to a fleet management system.

8. Method according to Claim 7,
**characterized**
**in that** the transmission is able to be performed wirelessly by a radio transmitter.

9. Method according to one of Claims 1 to 8,
**characterized**
**in that** the industrial truck has optional loads and, if the optional load is switched on or switched off, the average energy consumption is adjusted by a correction value.

10. Method according to Claim 9,
**characterized**
**in that** the controller is able to display an optional remaining time (4) for switched-on/switched-off optional loads on the display device.

## Revendications

1. Procédé de détermination de la durée de marche restante (4) d'un convoyeur au sol comprenant un accumulateur d'énergie d'alimentation du convoyeur au sol, des moyens de détection d'un degré de remplissage de l'accumulateur d'énergie, un dispositif de commande et un dispositif d'affichage, le convoyeur au sol comportant au moins deux modes de fonctionnement pour lesquels un dispositif d'entraînement et/ou un dispositif de travail ont des consommations d'énergie différentes pendant le fonctionnement du convoyeur au sol, et le dispositif de commande détermine une durée de marche restante (4) en fonction du contenu énergétique de l'accumulateur d'énergie à l'aide du degré de remplissage, et la durée de marche restante (4) étant calculée à partir du contenu énergétique et d'une consommation d'énergie moyenne et affichée sur le dispositif d'affichage,
**caractérisé en ce que**
les modes de fonctionnement ont différentes courbes d'accélération à maintenir et/ou différentes vitesses maximales pendant le fonctionnement et **en ce que**, en cas de changement de mode de fonctionnement, la consommation d'énergie moyenne est ajustée par une valeur de correction pour le mode de fonctionnement.

2. Procédé selon la revendication 1,
**caractérisé en ce que**
le convoyeur au sol fonctionne électriquement sur batterie et l'accumulateur d'énergie est une batterie de traction et le degré de remplissage correspond à un état de charge.

3. Procédé selon la revendication 1 ou 2,
**caractérisé en ce que**
la durée de marche restante (4) est affichée en heures de fonctionnement.

4. Procédé selon l'une des revendications 1 à 3,
**caractérisé en ce que**
la commande affiche alternativement sur le dispositif d'affichage le degré de remplissage et la durée de marche restante (4), en particulier un état de charge dans le cas d'un convoyeur au sol électrique à batterie.

5. Procédé selon l'une des revendications 1 à 4,
**caractérisé en ce que**
la commande peut afficher sur le dispositif d'affichage une durée de marche restante optionnelle pour au moins un mode de fonctionnement inactif.

6. Procédé selon l'une des revendications 1 à 5,
**caractérisé en ce que**
le convoyeur au sol est entraîné par un moteur à combustion interne et l'accumulateur d'énergie est un réservoir de carburant et le degré de remplissage correspond à un niveau de remplissage du réservoir de carburant.

7. Procédé selon l'une des revendications 1 à 6,
**caractérisé en ce que**
la commande peut transférer la durée de marche restante (4) à un système de gestion de flotte dans un réseau de données.

8. Procédé selon la revendication 7,
**caractérisé en ce que**
le transfert peut être effectué sans fil par un émetteur radio.

9. Procédé selon l'une des revendications 1 à 8,
**caractérisé en ce que**
le convoyeur au sol comporte des consommateurs optionnels et, lorsque le consommateur optionnel est activé ou désactivé, la consommation d'énergie moyenne est ajustée par une valeur de correction.

10. Procédé selon la revendication 9,
**caractérisé en ce que** la commande peut afficher sur le dispositif d'affichage une durée de marche restante optionnelle (4) pour des consommateurs optionnels activés/désactivés.
